Europäisches Patentamt

(19) European Patent Office

Office européen des brevets

(11) Publication number: **0 131 900**
A2

(12) # EUROPEAN PATENT APPLICATION

(21) Application number: **84108127.6**

(22) Date of filing: **11.07.84**

(51) Int. Cl.⁴: $H\ 03\ M\ 1/30$

(30) Priority: **13.07.83 DE 3325318**

(43) Date of publication of application:
**23.01.85 Bulletin 85/4**

(84) Designated Contracting States:
**AT DE FR GB IT SE**

(71) Applicant: **Litton Precision Products International GmbH**
**Oberföhringer Strasse 8**
**D-8000 München 80(DE)**

(72) Inventor: **Rammelsberg, Dieter**
**Tettnanger Strasse 4**
**D-8000 München 60(DE)**

(74) Representative: **Müller, Frithjof E.**
**Patentanwälte Dipl.-Chem. Dr. N. ter Meer Dipl.-Ing. F.E.**
**Müller Dipl.-Ing. H. Steinmeister Triftstrasse 4**
**D-8000 München 22(DE)**

(54) Incremental angular encoder.

(57) The incremental angular encoder has a device for the freely selected setting of an absolute zero or reference point. This additional device consists of a reduction gear (4), which is connected on the input side to the shaft (1) of the angular encoder and, on the output side, to a disk (5), which has an opto-electronically scannable hole or light reflection mark (11). The disk (5) is preferably a gear wheel which is connected, via a friction clutch, to the reduction gear (4) and which can be adjusted from outside by means of a toothed key (7) provided with a pinion, so that the absolute zero point can be exactly set. By selection of the gear wheels ($R_1, R_2, R_3, R_4$) of the reduction gear (4), the reduction ratio can be varied within wide limits and, consequently, the absolute zero point can be set over a wide range.

# FIG. 1

EP 0 131 900 A2

Incremental Angular Encoder

Priority: July 13, 1983, Federal Rupublic of Germany
         P  33 25 318.8

The invention concerns an incremental angular encoder,
i.e. a measurement sensor, which emits the instantaneous
angular position of an axle or shaft in the form of an
electrical digital signal.

There are two versions of angular encoders which emit
their output signals in a digital format. One version
covers the so-called absolute angular encoders, which
emit the angular information in a digital code, i.e. the
angular value is immediately available in absolute form
at any time, especially even after an operational interruption or a failure of the supply voltage of a system
in which the angular encoder is .installed. It is necessary to differentiate between these absolute angular encoders and the incremental angular encoders, which only sub-divide one revolution of the angular encoder shaft, i.e. a rotational angle of 360°, into a defined number of steps - "increments". The present invention converns these incremental angular encoders. So that the direction of rotation can be recognised, the increment information in the form of rectangular signals is emitted on two different channels, i.e. at two separate connections for example on a first channel A and a second channel B. Information on the direction of rotation con be derived by comparing a particular switching flank, for example a switching flank of the rectangular signals going in the positive direction, on the two channels relative to one another. If, for example, channel A switches before channel B, the angular encoding shaft is rotating clockwise. If, on the other hand, channel B switches before channel A, the shaft is rotating counter-clockwise. The output signals on both channels are usually emitted in the form of rectangular signals. In many incremental angular encoders, a so-called reference signal is also supplied; this appears once per revolution, i.e. after each 360° rotational angle of the shaft.

If such an incremental angular encoder is used in a system, for example as a distance measurement element - perhaps in an industrial robot - the rectangular signals supplied must be counted by an electronic counting device in order to obtain information, for example on the distance traversed by the tool at the free end of the arm of the robot. In contrast, when an absolute angular encoder is used, only a code converter is necessary because, as already mentioned, the absolute angular information is not lost even with a voltage interruption and there is a fixed relationship between the shaft angular position and the output signal. A disadvantage of absolute angular encoders, however, is the high price, which becomes disproportionately higher with increasing resolution, and likewise the increase in installation size as the resolution becomes greater. In contrast, the incremental angular encoder has the advantage of smaller installation size, particularly at high values of angular resolution, and a substantially lower price. However, an important disadvantage, which has already been discussed, is that after interruption and reconnection of the supply voltage, no information whatever is available on the angular position of the shaft and this is immediately lost again if the supply voltage fails - even briefly. To deal with these cases, an associated reference point must be established and, when the supply voltage is switched on, it is first necessary to drive the unit mechanically to this reference point so that the system can establish a zero point. This usually oocurs by logic connections between the reference signal, appearing once per revolution of the angular encoder shaft, and signals from proximity switches, end switches and the like, i.e. with substantial expenditure on additonal switches, which require additional wiring and adjustment work on installation of the robot and, last but not least, can represent an additional source of error.

In most cases, incremental angular encoders are used to measure distances. A distance of $X_n$ $\underline{/mm/}$, for example, is then represented by n output pulses or steps of the angular encoder. For this distance, several - often even very many - revolutions of the shaft of the angular encoder are generally necessary. It follows that the reference signal, of the angular encoder, appearing every 360°, i.e. once per revolution of the shaft, cannot be used alone for determining the system zero point. It is rather the association with the sensor signals already

- 4 -                                    0131900

mentioned which is necessary to ensure a reproducible system zero point. Particularly in the manufacture of industrial robots, however, difficulties arise in generating this system zero point because the necessary sensor must be attached for example to the front tool - i.e. the hand - which means that the electrical signal must be carried by cable possibly via several rotational and pivoting movements. In many cases, additional slip-ring transmissions must be used in the vicinity of joints.

The object of the invention is, therefore, to produce an incremental angular encoder characterized by a settable absolute zero or reference point, for which, therefore, no additional switches with the associated expenditure are required for the reproducible setting of system zero point.

An incremental angular encoder of the type in accordance with the invention has the features given in claim 1.

Advantageous extensions of the concept of the invention are characterized in the sub-claims.

An incremental angular encoder in accordance with the invention is characterized by an absolute zero point which can be set at the angular encoder itself.

The object is attained, in accordance with the invention, by making use of the requirement specified by the usual application that, generally speaking, an application system requires, per angular encoder, only one fixed mechanically associated reference point, which is produced directly in the angular encoder by providing a mechanical element, in particular a gear wheel, which is connected to the input shaft of the angular encoder via a reduction gearbox, which output shaft can only execute a maximum rotation of 360° for the maximum occurring shaft revolutions of the angular encoder in the particular application. This mechanical element is provided with a switch mark as the zero point reference, the switch mark being sensed by an electrical scanning device attached to the casing so that the desired zero point reference signal can be supplied. The element connected to the output side of the reduction gear is connected via a torsional protection, for example a friction clutch, to the reduction gear, so that the zero point can be set anywhere within the specified distance. The zero point switch mark can, for example, be a hole penetrating the rotating element or an applied mark, which is sensed by an opto-electronic scanning device to obtain the zero point reference signal.

In the preferred embodiment form, the rotating element is a disk or, in particular, a gear wheel, which is not rigidly connected to the output side of the reduction gear but via a friction clutch, so that the switch point of the zero mark can be set from outside by rotating the switch gear wheel using a special pinion-type toothed key.

The invention and advantageous details are described more precisely below as an illustrative embodiment form in which:

Fig. 1    shows the diagrammatic representation of an embodiment example of an incremental angular encoder in accordance with the invention;

Fig. 2    shows a diagrammatic representation of the reduction gear indicated by the reference number 4 in Fig. 1; and

Fig. 3    shows a diagrammatic representation of the time
          relationship of the signals at the output terminals of an incremental angular encoder in
          accordance with the invention.

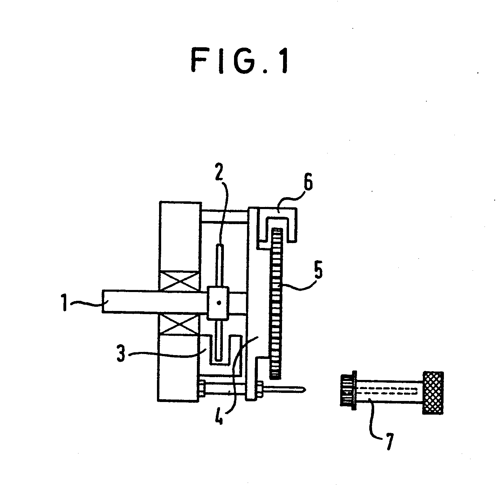

In the diagrammatic representation, shown in Fig. 1, of
an incremental angular encoder with features in accordance with the invention, the shaft of the angular encoder is indicated by 1, a glass disk rotating with the
shaft 1 and provided along its outer periphery with
chromium increments is indicated by 2 and an opto-electronic converter unit connected to the casing is indicated
by 3, which converter unit converts, by means of known
analysis electronics, the periodical switching on and off
of an infra-red light beam - caused by the chromium increments on the glass disk 2 - into the rectangular
measurement signal mentioned above. A further chromium
increment is located on the glass disk once per revolution
and this produces the reference signal mentioned - by
means of the same opto-electronics.

A reduction gear 4 is connected on the input side to the
shaft 1 and, on the output side, via a friction clutch -
which is not shown - to a gear wheel 5, which has, on its
edge, at least one hole or reflection mark which is sensed
by a further opto-electronic scanning device 6.

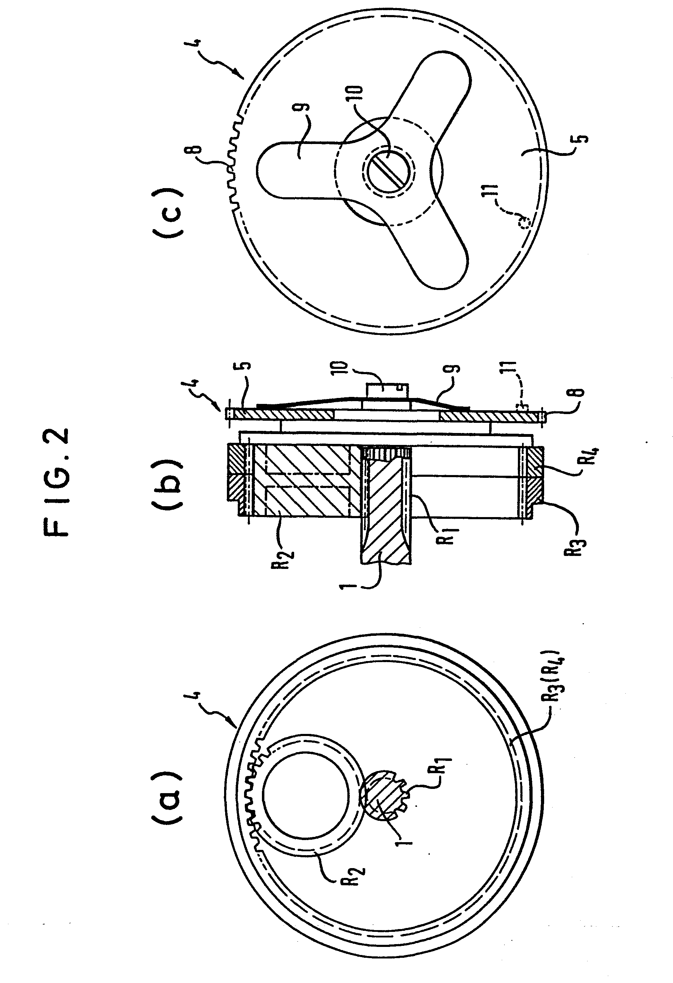

Fig. 2 shows a diagrammatic representation of the reduction gear 4. The reduction ratio of this gear 4 can be
selected for the particular requirements; for example,
in such a way that at the point of use (perhaps on a robot)
and for a distance to be traversed by a tool, only one
zero point reference point is generated, for example, for
50 revolutions of the shaft 1. In order to be able to set
this zero point reference point, the gear wheel 5 is rotated, by a special pinion-type toothed key 7 which engages in external teeth 8 provided for this purpose on the gear wheel 5, until the zero point reference signal appears at the desired zero setting of the robot tool.

The central part (b) of Fig. 2 shows the reduction gear in a diagrammatic sectional representation, while the left-hand part (a) reproduces the view of the reduction gear 4 from the input side and the right-hand part (c) the view from the output side. The shaft 1, together with a pinion $R_1$ applied to its end, forms the gear input. This pinion $R_1$ engages with a planetary gear wheel $R_2$, which in turn engages with two internally toothed wheels, namely with a fixed gear wheel $R_3$ and an, axially, immediately adjacent gear wheel $R_4$, which forms the output side of the reduction gear 4. The loose output side, internally toothed gear wheel $R_4$ is connected to the gear wheel 5 by means of a friction disk 9 secured by a screw 10, the gear wheel 5 having the hole or reflection mark, already mentioned and indicated by the reference number 11, at its edge. The gear wheel 5 is pressed against the output side gear wheel $R_4$ by the clamping effect of the friction disk 9. Because of the external teeth 8, however, the gear wheel 5 can be rotated from outside, in the manner mentioned, by means of the special pinion-type toothed key 7. For reasons of weight saving and to reduce the frictional surface, the planetary gear wheel $R_2$ can be relieved, as shown dotted.

In an embodiment example which has been proved in practice, a tooth module of 0.3 was selected and, for selected numbers of teeth of $Z_{R1} = 42$, $Z_{R2} = 42$, $Z_{R3} = 126$ and $Z_{R4} = 129$, a reduction ratio of U = 172 was obtained from the formula

$$U = \frac{2 \times Z_{R4} \times (Z_{R1} + Z_{R2})}{3 \times Z_{R1}}$$

In the example selected, the difference in the numbers of teeth between the gear wheel $R_3$ and the gear wheel $R_4$ is three teeth. In this case, three planetary gear wheels $R_2$ can be used, these being located with a displacement of exactly 120° in each case in order to provide better centering. This, however, makes no difference in principle to the manner of operation of the gear. If the difference in the numbers of teeth between the internally toothed gear wheels $R_3$ and $R_4$ is two teeth, then two planetary gear wheels $R_2$ can be provided, whereas with a tooth difference of one tooth, only one planetary gear wheel $R_2$ can be used.

The examples quoted show that the reduction ratio U of the reduction gear 4 can be varied over a wide range by an appropriate choice of the numbers of teeth on the pinion $R_1$, on the planetary gear wheel $R_2$ and/or on the fixed gear wheel $R_3$ and loose gear wheel $R_4$.

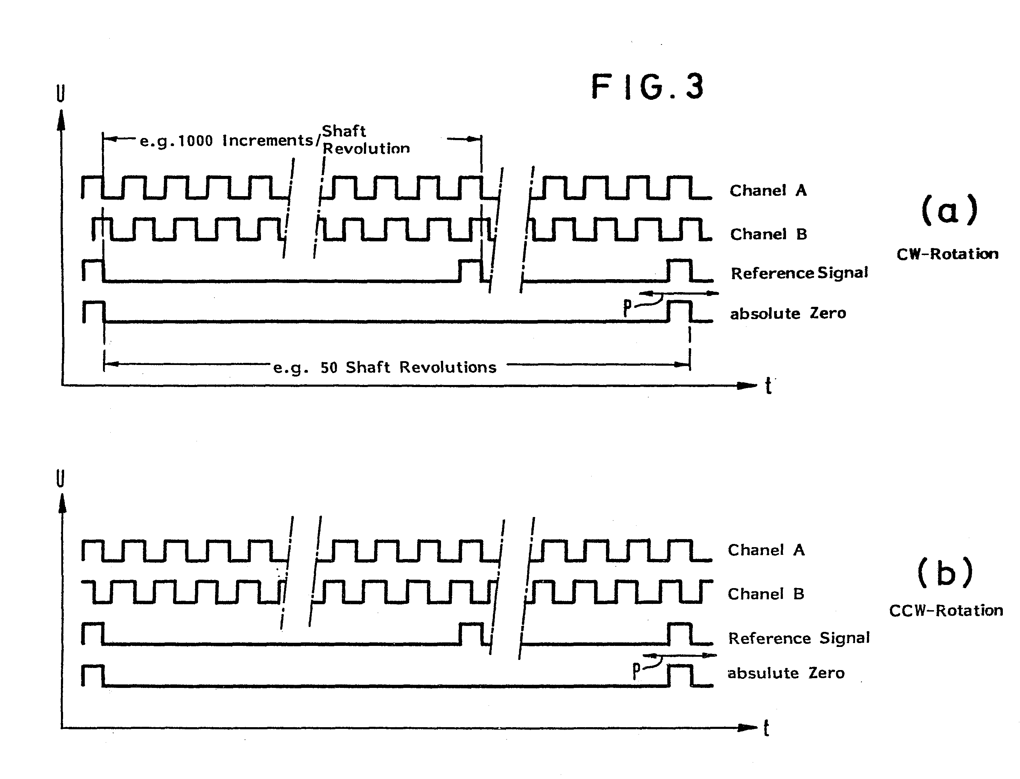

Fig. 3 shows two examples of the time relationship of the rectangular measurement signals at the output of the analysis electronics, one for clockwise rotation (Fig. 3(a)) and the other for counter-clockwise rotation (Fig.3(b)) of the shaft 1. Differentiation between clockwise and counter-clockwise rotation can be carried out by means of the different channels A and B. If a particular signal edge, for example a falling edge, appears earlier on channel A than on channel B, then rotation is to the right. The reference signal appears, with reference to the channel A, after each revolution of the shaft 1. For one revolution of the shaft 1, 1000 rectangular pulses, for example, appear as 1000 increments. The absolute zero point given in the bottom line of both signal diagrams can, but does not have to, be matched to a cyclic reference signal; a slight displacement in time can also be provided. In the example shown, a rectangular signal giving the absolute zero point appears, in each case after, for example, 50 revolutions of the shaft 1. The "spatial" displaceability of the absolute zero point is indicated by an arrow P; the absolute zero point can be displaced, as described above, firstly - with respect to the number of revolutions of the shaft 1 per rectangular pulse of the absolute zero point - by appropriate choice of the gear wheels of the reduction gear 4 and, secondly - relative to the cyclic reference signal (third line of the diagrams in Fig. 3) - by mean of the special key 7.

C131900

# C l a i m s

1.    An incremental angular encoder, which comprises a device for the freely selected setting of an absolute zero point, to which belongs an element, connected to the shaft (1) of the angular encoder but rotatable relative to this shaft and having a zero point mark, and an electrical scanning device (6), which is connected to the casing, senses the zero point mark as an absolute zero point mark and converts it into an electrical switching or reference signal.

2.    An angular encoder as claimed in claim 1, wherein
- the element with the zero point mark is a disk, which is connected to the output side of a reduction gear (4), whose input side is positively connected to the shaft (1) of the angular encoder, and
- the zero point mark is a hole, penetrating the disk, or an applied light reflection mark, whose position can be sensed by an opto-electronic scanning device (6).

3.    An angular encoder as claimed in claim 1 or 2, wherein the element rotatable relative to the shaft is provided with a friction clutch.

4.    An angular encoder as claimed in claim 2, wherein the disk (5) is connected via a friction clutch to the reduction gear (4).

5.    An angular encoder as claimed in claim 4, wherein the disk (5) is a gear wheel which can be rotated, for absolute zero point setting, relative to the shaft (1) of the angular encoder by means of a toothed key (7) matched to the teeth of the gear wheel.

6.     An angular encoder as claimed in claim 2, wherein the reduction gear (4) is of flat construction, has a pinion input shaft connected to the shaft (1) of the angular encoder, and depending on the gear ratio selected, has one to three free-running gear wheel(s), which engage(s) simultaneously in the pinion input shaft and in two internally toothed gear wheels, of which one forms the gear output side (5).

0131900

# FIG.1

FIG.2

(a)

(b)

(c)

# FIG. 3

e.g. 1000 Increments/Shaft Revolution

Chanel A

Chanel B

Reference Signal

absolute Zero

**(a)**

CW-Rotation

P

e.g. 50 Shaft Revolutions

Chanel A

Chanel B

Reference Signal

absulute Zero

**(b)**

CCW-Rotation

P

Litton Precision Products Int GmbH

0131900